# FASCICULE DE BREVET EUROPEEN

(11) **EP 4 572 594 B1**
(45) Date de publication et mention de la délivrance du brevet: **17.06.2026**
(21) Numéro de dépôt: 24219196.3
(22) Date de dépôt: 11.12.2024
(51) Int. Cl.: H10N 70/20, H10B 63/00, H10B 53/30

(54) **STRUCTURE DE MÉMOIRE NON-VOLATILE A EMPILEMENT DANS EMPLACEMENT DE VIA ET DE LIGNE CONDUCTRICE SUR CE VIA ET SON PROCÉDÉ DE FABRICATION**
NICHTFLÜCHTIGE SPEICHERSTRUKTUR MIT EINEM STAPEL ANGEORDNET IN EINEM VIA UND EINER LEITUNG DARÜBER SOWIE DEREN HERSTELLUNGSVERFAHREN
NONVOLATILE MEMORY STRUCTURE WITH A STACK LOCATED IN A VIA AND IN A CONDUCTIVE LINE THEREON AND FABRICATION PROCESS THEREOF

(30) Priorité: 12.12.2023 FR 2314040
(43) Date de publication de la demande: 18.06.2025
(73) Titulaire: Commissariat à l'Energie Atomique et aux Energies Alternatives, 75015 Paris (FR)
(72) Inventeur: BORREL, Julien, 38054 Grenoble Cedex 09 (FR); GRENOUILLET, Laurent, 38054 Grenoble Cedex 09 (FR); JAHAN, Carine, 38054 Grenoble Cedex 09 (FR); RICAVY, Sébastien, 38054 Grenoble Cedex 09 (FR)
(74) Mandataire: Santarelli

(56) Documents cités:
- WO-A1-2015/147801
- US-A1- 2024 274 532
- US-B1- 9 553 265

## Description

### DOMAINE TECHNIQUE

La présente invention se rapporte au domaine des mémoires non-volatiles formées à partir d'un empilement de couches et comportant au moins une couche de matériau actif entre deux électrodes. Elle concerne plus particulièrement celui des mémoires ferroélectrique FeRAM, des mémoires résistives OxRAM et des mémoires ferroélectriques à jonction tunnel (FTJ).

La présente invention prévoit un dispositif microélectronique à structure mémoire non-volatile dont l'agencement amélioré ainsi qu'un procédé amélioré de fabrication d'un tel dispositif.

### ART ANTERIEUR

Les mémoires ferroélectriques ou mémoires FeRAM ont pour qualité d'être non volatiles, c'est-à-dire de pouvoir conserver une information stockée même quand leur alimentation est coupée, de consommer peu d'énergie, d'avoir des temps d'écriture et de lecture faibles, de pouvoir être intégrées sur des puces de façon massive avec des faibles tensions d'utilisation et de posséder une faible latence en accessibilité et une bonne immunité aux radiations. En outre, ce type de mémoire présente une très grande endurance en écriture. Ces mémoires ont un fonctionnement basé sur les propriétés ferroélectriques de leur matériau actif placé entre deux électrodes. Par application d'une différence de potentiels entre les deux électrodes créant un champ électrique d'une valeur supérieure au champ coercitif positif, la mémoire ferroélectrique est placée dans un état de polarisation rémanente haute et par application d'une différence de potentiels créant un champ électrique d'une valeur inférieure au champ coercitif négatif, la mémoire ferroélectrique est placée dans un état de polarisation rémanente basse. L'état de polarisation rémanente haute correspond alors à un premier état logique donné, par exemple '0' et l'état de polarisation rémanente basse à un état logique complémentaire, par exemple '1', ce qui permet le stockage de l'information.

Un autre type de mémoire dite résistive telle que les mémoires OxRAM pour « Oxide Resistive RAM » repose quant à elle sur un matériau actif entre deux électrodes présentant au moins deux états résistifs, correspondant à un état fortement résistif (état « HRS » pour « High Resistance State ») et à un état faiblement résistif (état « LRS » pour « Low Resistance State »), sous l'application d'une tension. Les mémoires OxRAM ont pour principales qualités d'être non volatiles, d'avoir des temps d'écriture et de lecture faibles, de pouvoir être intégrées sur des puces de façon massive, et de posséder une faible latence en accessibilité et une bonne immunité aux radiations et en température. Les mémoires OxRAM présentent typiquement une structure M-I-M (Métal-Isolant-Métal) comprenant un matériau actif de résistance électrique variable, en général un oxyde de métal de transition, disposé entre deux électrodes métalliques. Le passage de l'état « HRS » à l'état « LRS » est gouverné par la formation et la rupture d'au moins un filament conducteur entre les deux électrodes. Ce filament conducteur se créé grâce à la présence de lacunes d'oxygène présentes dans la couche active de la mémoire. En modifiant les potentiels appliqués aux électrodes, il est possible de modifier la répartition du filament et de modifier ainsi la conduction électrique entre les deux électrodes. Dans la couche active, le filament électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé aboutissant à l'état LRS, et de RESET aboutissant à l'état HRS, lorsque le filament est rompu à nouveau par application respective d'une tension de SET, VSET ou de RESET, VRESET aux bornes des électrodes).

Les mémoires ferroélectriques à jonction tunnel (FTJ pour « Ferroelectric Tunnel Junction » ou ferroélectrique à jonction tunnel ») sont des mémoires utilisant le changement de résistance électrique d'un matériau actif de type ferroélectrique agencé entre deux électrodes pour stocker l'information, avec une faible volatilité, une haute densité d'informations.

Les mémoires précitées ont pour comme point commun d'être formées à partir d'un empilement de couches comportant au moins un matériau actif agencé entre deux électrodes.

De nos jours, on réalise ce type d'empilement mémoire principalement dans un ultime niveau métallique d'interconnexion.

Un exemple de réalisation dans un ultime niveau métallique d'interconnexion est donné dans le document intitulé « 16kbit HfO2:Si-based 1T-1C FeRAM Arrays Demonstrating High Performance Operation and Solder Reflow Compatibility », François, 2021 IEDM. Ce document prévoit en particulier un agencement « 2D » (autrement dit planaire) d'un tel empilement.

Afin d'augmenter la surface développée de l'empilement et améliorer les performances, des agencements dits « 3D » sont apparus. Le document : "Ferroelectric deep trench capacitors based on Al:HfO2 for 3D non-volatile memory Applications", Polakowski, 2014 IEEE International Memory Workshop (IMW) présente par exemple un tel type d'agencement, dans lequel l'agencement s'étend dans une région particulière dans laquelle une pluralité de tranchées juxtaposées ont été formées. Des dispositifs de mémoire non-volatile selon le préambule de la revendication indépendante 1 sont connus, par exemple, à partir des documents US 9 553 265 B1 et WO 2015/147801 A1.

La réalisation d'un tel agencement peut nécessiter de dédier une zone particulière d'un dispositif microélectronique à la structure mémoire et des étapes supplémentaires et spécifiques de photolithographie. Elle pose également des difficultés en termes de prise de contact sur l'électrode inférieure ou supérieure.

Il existe donc un besoin de pallier l'un ou plusieurs des inconvénients mentionnés ci-dessus.

### EXPOSÉ DE L'INVENTION

Selon un aspect la présente invention prévoit un dispositif microélectronique comprenant :
- un substrat comportant une pluralité de niveaux métalliques d'interconnexions superposés,
- une structure de mémoire non-volatile agencée sur une première ligne conductrice d'un premier niveau métallique d'interconnexion, la structure de mémoire non-volatile comprenant un empilement comportant une électrode inférieure et une électrode supérieure et au moins une couche de matériau actif entre l'électrode inférieure et l'électrode supérieure, le dispositif comprenant en outre:
- la première ligne conductrice du premier niveau d'interconnexion, et une deuxième ligne conductrice dudit premier niveau métallique d'interconnexion, la deuxième ligne conductrice étant distincte de la première ligne conductrice, la première ligne conductrice et la deuxième ligne conductrice étant agencées dans un même premier plan parallèle ou sensiblement parallèle à un plan principal du substrat,
- une troisième ligne conductrice appartenant à un deuxième niveau métallique d'interconnexion supérieur par rapport audit premier niveau d'interconnexions, la troisième ligne conductrice étant agencées dans un deuxième plan parallèle au plan principal du substrat et au-dessus du premier plan de sorte que le premier plan est agencé entre le deuxième plan et le plan principal du substrat, la troisième ligne conductrice étant connectée à la deuxième ligne conductrice par l'intermédiaire d'un via conducteur, le via conducteur s'étendant dans une région intermédiaire entre ledit premier plan et ledit deuxième plan, l'électrode inférieure, l'électrode supérieure et ladite au moins une couche de matériau actif dudit empilement de la structure non-volatile s'étendant dans le niveau métallique d'interconnexion supérieur et dans ladite région intermédiaire.

Avec une telle configuration, on peut mettre en œuvre un empilement mémoire avec une surface développée d'importante tout en limitant l'encombrement dans le plan de la structure mémoire et en s'éloignant d'une zone de dite de « front-end » correspondant au niveau dans lequel des composants tels que des transistors sont formés.

La structure de mémoire non-volatile (NVM) peut avantageusement comprendre une partie supérieure de section transversale donnée et une partie inférieure de section transversale différente de la section transversale donnée.

Avantageusement, la troisième ligne conductrice et le via conducteur traversant une épaisseur isolante, l'épaisseur isolante s'étendant sur la première ligne conductrice et la deuxième ligne conductrice, ledit empilement de la structure non-volatile tapissant des parois latérales ainsi qu'un fond d'une tranchée et d'un trou situé dans le prolongement de cette tranchée, le trou et la tranchée étant agencés dans ladite épaisseur isolante, l'empilement étant disposé au fond du trou sur la première ligne conductrice.

Avantageusement, le trou est prévu avec une largeur W1 et la tranchée est prévue avec une largeur W2 telle que W2 > W1, de sorte que la structure non-volatile comporte une portion inférieure et une portion supérieure élargie par rapport à la portion inférieure. Une telle configuration facilite la prise de contact sur la partie supérieure de la structure mémoire.

Selon une possibilité de mise en œuvre, la hauteur H cumulée du trou et de la tranchée est sensiblement égale à la hauteur hc cumulée du via conducteur et de la troisième ligne conductrice.

Une telle configuration participe à la mise en œuvre d'une structure mémoire intégrée dans les niveaux d'interconnexion standards / conventionnels et ayant une surface développée importante mais sans avoir à prévoir des règles de dessins spécifiques pour la concevoir.

Selon une possibilité de mise en œuvre, le procédé comprend en outre :
- un premier via conducteur supérieur ayant une extrémité inférieure disposée sur et en contact de la structure de mémoire non-volatile (NVM) et s'étendant, dans une épaisseur isolante, entre cette extrémité inférieure et une extrémité supérieure,
- un deuxième via conducteur supérieur ayant une extrémité inférieure disposée sur et en contact avec la troisième ligne conductrice, et s'étendant dans ladite épaisseur isolante entre son extrémité inférieure et une extrémité supérieure,
le premier via conducteur supérieur et le deuxième via conducteur supérieur ayant des hauteurs respectives égales mesurées entre d'une part leurs extrémité inférieure et d'autre part leur extrémité supérieure.

Avantageusement, ledit via conducteur a une extrémité inférieure en contact avec la deuxième ligne conductrice et une extrémité supérieure en contact avec la troisième ligne conductrice, ledit via conducteur et la troisième ligne conductrice étant agencées dans au moins une couche isolante, une face inférieure de la couche isolante étant disposée sur et en contact de la première ligne conductrice et de la deuxième ligne conductrice,

la structure non-volatile s'étendant entièrement dans ladite couche isolante, entre la face inférieure de la couche isolante et un plan passant à la fois par une face supérieure de la couche isolante opposée à la face inférieure, l'extrémité inférieure du premier via conducteur supérieur et par l'extrémité inférieure du deuxième via conducteur supérieur.

Selon une possibilité de mise en œuvre, l'électrode inférieure, l'électrode supérieure et l'au moins une couche de matériau actif dudit empilement de la structure non-volatile (NVM) s'étendent sous forme d'une quatrième ligne conductrice, distincte de la troisième ligne conductrice et appartenant au deuxième niveau métallique d'interconnexion et sous la forme d'au moins un autre via conducteur dans le prolongement de la quatrième ligne conductrice et pour contacter la première ligne conductrice.

Dans ce cas, avantageusement, la quatrième ligne conductrice et ledit autre via, ont un profil transversal (ou une section transversale) sensiblement identique à celui (resp. celle) de la troisième ligne conductrice et dudit via conducteur.

Avantageusement, le dispositif peut être également pourvu d'un via conducteur supplémentaire agencé sur et en contact d'une portion supérieure de la structure mémoire.

De préférence, l'électrode supérieure est dotée ou revêtue d'une zone de matériau conducteur de remplissage du trou et de la tranchée, le via conducteur supplémentaire étant disposé sur et en contact de la portion supérieure de la structure mémoire sans être disposé en contact avec le matériau actif ou l'électrode inférieure.

De même, de manière avantageuse un autre via conducteur supplémentaire peut être prévu sur la troisième ligne conductrice.

Ainsi, selon une possibilité de mise en œuvre, un ou plusieurs niveaux conducteurs ou métalliques supplémentaires d'interconnexion peuvent être prévus sur ou au-dessus de la structure de mémoire non-volatile.

Selon une première mise en œuvre particulière, la structure de mémoire non-volatile peut être de type FeRAM, le matériau actif étant alors formé d'une couche de diélectrique ferroélectrique.

Selon une variante mise en œuvre, la structure de mémoire non-volatile peut être de type OXRAM, le matériau actif étant formé d'au moins une couche d'oxyde diélectrique.

Selon une autre variante mise en œuvre, la structure de mémoire non-volatile peut être de type FTJ, le matériau actif étant formé d'au moins une couche de diélectrique ferroélectrique en contact avec une couche d'un autre matériau diélectrique.

Selon une autre variante mise en œuvre, la structure de mémoire non-volatile peut être de type CBRAM, le matériau actif étant formé d'au moins une couche d'électrolyte.

Selon un autre aspect, la présente invention prévoit la mise en œuvre d'un procédé de réalisation d'un dispositif microélectronique tel que défini plus haut.

Selon un autre aspect, la présente invention concerne un procédé de fabrication d'un dispositif microélectronique muni d'une structure de mémoire non-volatile (NVM) formée d'un empilement comportant au moins une électrode inférieure et au moins une électrode supérieure et au moins un matériau actif entre l'électrode inférieure et l'électrode supérieure, le procédé comprenant les étapes suivantes :
- prévoir un substrat revêtu d'au moins un couche isolante, une première ligne conductrice et une deuxième ligne conductrice d'un niveau d'interconnexion donné (Mx-1) s'étendant dans la couche isolante et dans un même premier plan parallèle à un plan principal du substrat,
- former une épaisseur isolante sur la première ligne conductrice, la deuxième ligne conductrice et ladite couche isolante,
- former dans ladite épaisseur isolante, un trou dévoilant la première ligne conductrice et une tranchée dans le prolongement de ce trou,
- déposer dans la tranchée et dans le trou un empilement comprenant au moins au moins une couche d'électrode inférieure, au moins une couche de matériau actif et au moins une couche d'électrode supérieure, ledit empilement tapissant des parois latérales et un fond du trou et de la tranchée.

Un tel procédé permet de concilier surface développée importante de la structure mémoire et encombrement de cette structure.

Un tel procédé permet également de réaliser la structure mémoire sans nécessairement prévoir des règles de dessins spécifiques.

Outre les avantages précités, la réalisation de l'empilement à un niveau éloigné des composants formés dans une couche semi-conductrice du substrat permet de le préserver d'étapes au budget thermique élevé.

Avantageusement, le dépôt dans la tranchée et dans le trou dudit empilement est suivi du remplissage de la tranchée et du trou par dépôt d'un matériau métallique, de sorte à combler le trou et la tranchée.

Le dépôt de l'empilement est typiquement un dépôt conforme et peut être avantageusement réalisé par ALD.

Selon une possibilité de mise en œuvre, le procédé peut comprendre en outre la formation dans l'épaisseur isolante d'un via conducteur en contact avec la deuxième ligne conductrice et d'une troisième ligne conductrice sur le via conducteur.

Selon une première possibilité de mise en œuvre du procédé, la réalisation du via conducteur et de la troisième ligne conductrice peut comprendre des étapes de :
- réalisation d'un premier masquage en regard de la première ligne conductrice et comportant au moins une ouverture en regard de la deuxième ligne conductrice,
- gravure à travers l'ouverture du premier masquage d'une autre tranchée et d'un autre trou dans le prolongement de l'autre tranchée et ayant un fond dévoilant la deuxième ligne conductrice,
- remplissage de l'autre tranchée et de l'autre trou à l'aide d'au moins un matériau conducteur,
le procédé comprenant en outre :
- retrait du premier masquage et formation d'un deuxième masquage comportant au moins une ouverture en regard de la première ligne conductrice, gravure de l'épaisseur isolante à travers l'ouverture du deuxième masquage pour former la tranchée et le trou.

Selon une deuxième possibilité de mise en œuvre du procédé, la réalisation du via conducteur et de la troisième ligne conductrice peut comprendre la formation d'une autre tranchée et d'un autre trou dans le prolongement de l'autre tranchée, l'autre trou ayant un fond dévoilant la deuxième ligne conductrice, le trou dévoilant la première ligne conductrice et l'autre trou dévoilant la deuxième ligne conductrice étant formés concomitamment.

Avantageusement, la tranchée, l'autre tranchée, le trou et l'autre trou peuvent être formés par gravure de l'épaisseur isolante à travers une ou plusieurs ouvertures d'un premier masquage. Le procédé peut alors comprendre en outre des étapes de :
- remplissage de la tranchée, de l'autre tranchée, du trou et de l'autre trou à l'aide d'au moins un matériau conducteur,
- retrait du premier masquage et formation d'un deuxième masquage en regard de la deuxième ligne conductrice et de la troisième ligne conductrice, le deuxième masquage comportant au moins une ouverture en regard de la première ligne conductrice,
le procédé comprenant en outre des étapes de :
- retrait du matériau conducteur de la tranchée et du trou par gravure à travers l'ouverture du deuxième masquage, de sorte à libérer à nouveau la tranchée et le trou,
- formation de l'empilement dans la tranchée et le trou.

Selon une possibilité de mise en œuvre la ou les couches de matériau actif peu(ven)t est formée(s) :
- d'un diélectrique ferroélectrique, en particulier un oxyde tel que du HfO₂ dopé au Si ou du HfZrO₂, ou
- d'un oxyde diélectrique tel que du HfO₂, ou
- d'une couche d'électrolyte, en particulier à base d'un oxyde métallique tel que du HfO₂ ou du Al₂O₃ ou du Ta₂O₅ ou à base d'un chalcogénure tel que du GeSe ou du GeTe ou du GeSbTe,
- d'un empilement d'un diélectrique ferroélectrique et d'un autre diélectrique.

De préférence, l'autre diélectrique est choisi de sorte à présenter un grand gap (i.e. une différence importante entre sa bande de valence et sa bande de conduction) afin de présenter une résistance tunnel importante à faible épaisseur.

Selon une possibilité de mise en œuvre, l'électrode inférieure et l'électrode inférieure peuvent être formées :
- d'une couche en un premier matériau choisi en particulier parmi un ou plusieurs des matériaux suivants : Ti, TiN, W
- d'une couche en un matériau métallique choisi en particulier parmi un ou plusieurs des matériaux suivants : W, Cu, Al, AlCu, AlSi.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A et 1B illustrent un agencement particulier d'une structure de mémoire non-volatile formée d'un empilement et intégrée à un même niveau que celui respectivement d'un via conducteur et d'une ligne conductrice d'interconnexion.
Les figures 2A, 2B et 2C illustrent différents exemples d'empilements à partir des quels la structure de mémoire non-volatile est susceptible d'être formée.
La figure 3 illustre une structure de départ possible pour la mise en œuvre d'un dispositif microélectronique suivant l'invention.
Les figures 4A à 4F illustrent un premier exemple de procédé de fabrication d'une structure de mémoire non-volatile formée d'un empilement dans une épaisseur isolante dans laquelle un ou plusieurs vias conducteurs et une ou plusieurs lignes conductrices d'un niveau métallique d'interconnexion sont également formés.
Les figures 5A à 5D illustrent un deuxième exemple de procédé de fabrication d'une structure de mémoire non-volatile pour laquelle l'emplacement de l'empilement sous forme de trou et de tranchée dans une épaisseur isolante est réalisé à celui d'un via conducteur et d'une ligne conductrice dans cette même épaisseur.
Les figures 6A et 6B illustrent des agencements d'empilements qui ne font pas partie de l'invention revendiquée.
La figure 7 illustre un exemple de réalisation dans lequel la structure de mémoire non-volatile est formée d'un empilement de couches et est connectée à un via conducteur disposé sur cet empilement.
La figure 8 illustre un agencement particulier d'une structure de mémoire non-volatile avec une partie supérieure qui forme une ligne conductrice.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

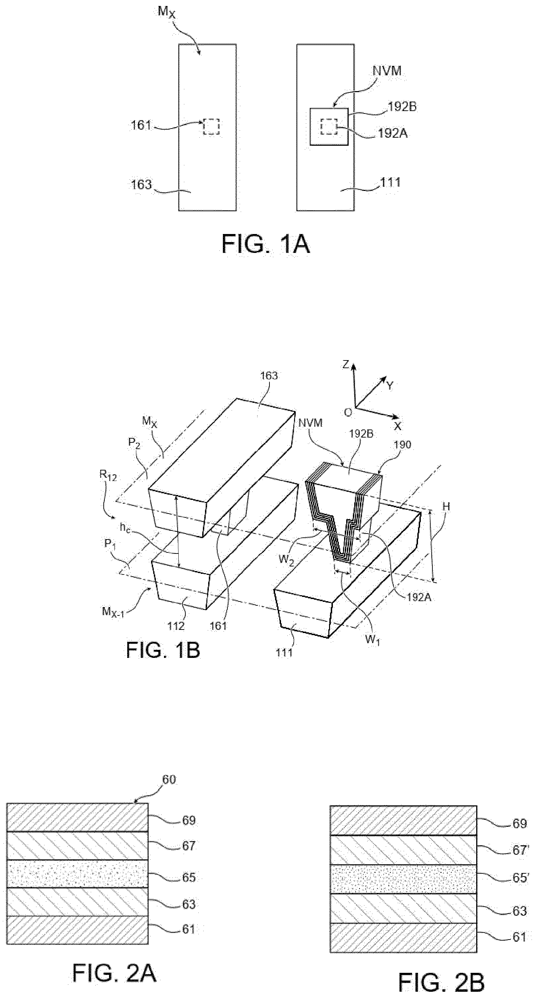

On se réfère tout d'abord aux figures 1A et 1B donnant respectivement, selon une vue de dessus et selon une vue en perspective, un exemple de structure de mémoire non-volatile NVM formée dans un niveau Mx (avec x supérieur ou égal à 1 et typiquement au moins égal à 3) d'interconnexions d'un dispositif microélectronique.

La structure de mémoire non-volatile NVM est ici réalisée dans un niveau communément appelé de « back end » du dispositif, au-dessus d'un niveau de « front-end » sous-jacent et dans lequel les composants en semi-conducteur et en particulier les transistors sont prévus.

La structure de mémoire non-volatile NVM peut être par exemple de type FeRAM, ou OxRAM ou FTJ ou CBRAM et est dotée d'une portion inférieure 192A disposée sur et en contact d'une première ligne conductrice 111, ici une ligne métallique d'un niveau d'interconnexion donné Mx-1 parmi une pluralité de niveaux métalliques d'interconnexions du dispositif microélectronique.

Cette portion inférieure 192A peut avoir une forme d'un via conducteur et est située au même niveau qu'un autre via conducteur 161 Par « via conducteur » on entend un élément conducteur dit « vertical » et s'étendant entre deux lignes conductrices de niveaux différents et situées dans des plans distincts.

Le via conducteur 161 assure ici la connexion entre une deuxième ligne conductrice 112 du même niveau donné Mx-1 que la première ligne 111 et une troisième ligne conductrice 163 d'un niveau Mx supérieur au niveau donné. La première ligne conductrice 111 et la deuxième ligne conductrice 112 sont ainsi agencées dans un même premier plan P₁. La première ligne conductrice 111 et la deuxième ligne conductrice 112 sont distinctes et de préférence non connectées et/ou non sécantes.

La structure de mémoire non-volatile NVM comporte également une portion supérieure 192B disposée au même niveau Mx que la troisième ligne conductrice 163. La troisième ligne conductrice 163 est ici agencée dans un même deuxième plan P2, parallèle au premier plan P1, que la portion supérieure 192B de la structure NVM.

De préférence, le niveau Mx ne correspond pas au dernier niveau de « back-end » du dispositif de sorte qu'il existe un ou plusieurs niveaux métalliques supérieurs au niveau Mx. Ainsi un ou plusieurs niveaux supplémentaires (non représentés) de lignes conductrices peuvent être prévus au-dessus de la troisième ligne conductrice 163. La structure de mémoire non-volatile NVM est donc ici avantageusement prévue entre la partie « front end » du dispositif et l'ultime niveau de « back-end » sur lequel des plots ou des bosses de contact sont typiquement disposé(e)s.

La portion supérieure 192B de la structure mémoire NVM peut être ici prévue avec une largeur W2 ou dimension critique plus importante que la largeur ou dimension critique W₁ de la portion supérieure 192A (W₁ et W₂ étant des dimensions mesurées parallèlement à l'axe x sur la figure 1B et qui correspondent à la plus petite dimension d'un motif mesuré parallèlement au plan [O ;x ;y]). La largeur W₂ peut être avantageusement prévue de l'ordre de celle d'une ligne conductrice 163 située au même niveau, par exemple entre 20 nm et 60 nm.

La hauteur H cumulée de la portion inférieure 192A et de la portion supérieure 192B peut être prévue de l'ordre de celle cumulée du via conducteur 161 et de la ligne conductrice 163. Ainsi, l'agencement de la structure mémoire NVM n'induit ici pas nécessairement de modification de règles de dessins ou de perte de densité.

La structure de mémoire non-volatile NVM est formée d'un empilement 190 comprenant au moins une électrode inférieure et une électrode supérieure ainsi qu'au moins un matériau actif agencé entre l'électrode inférieure et l'électrode supérieure. L'électrode inférieure, l'électrode supérieure et le matériau actif de cet empilement mémoire s'étendent ici à la fois dans le niveau métallique d'interconnexion Mx supérieur et dans une région intermédiaire R₁₂ située entre le premier plan P1 et le deuxième plan P2.

Différentes compositions d'empilement peuvent être envisagées en fonction du type de structure mémoire NVM mise en œuvre.

Un exemple particulier d'empilement 60 est donné sur la figure 2A pour une structure de type FeRAM. Il est doté d'une couche 63 d'électrode inférieure, revêtue d'une couche de diélectrique ferroélectrique 65, elle-même revêtue d'une couche d'électrode supérieure 67. Avantageusement, la couche 63 d'électrode inférieure peut être disposée sur et en contact d'une couche métallique 61. De même, une couche métallique 69 peut être avantageusement disposée sur et en contact de la couche d'électrode supérieure 67. La couche de diélectrique ferroélectrique 65 peut être par exemple à base de HfO₂ dopé en particulier au Si ou à base de HfZrO₂, éventuellement dopé, par exemple au lanthane (La), ou à l'aluminium (AI). Les couches 63, 67 d'électrode inférieure et supérieure peuvent être formées par exemple à base de TiN ou de W ou d'un empilement de Ti et de TiN pour la couche d'électrode 63 inférieure. 61. Les couches métalliques 61, 69 peuvent quant à elles être par exemple prévu à base de W, de Cu, d'Al, d'AlCu, d'AISi.

Un exemple particulier d'empilement pour mettre en œuvre une structure NVM de type OxRAM est donné sur la figure 2B. Il diffère notamment de l'empilement décrit précédemment de par la composition d'au moins une de ses électrodes, ici de par la couche d'électrode haute 67', contenant de préférence un matériau conducteur oxydable tel que par exemple du Ta ou du Ti ou du Hf. La couche active disposée entre les électrodes est un diélectrique 65' de type oxyde diélectrique, en particulier un oxyde de l'un des matériaux conducteurs oxydables évoqués précédemment, par exemple du HfO₂.

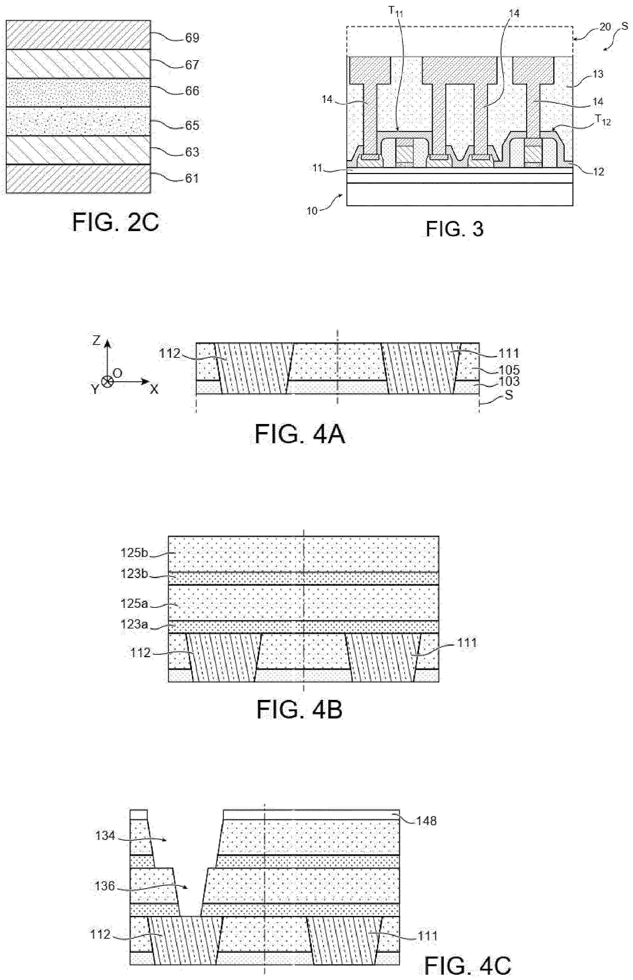

Un autre exemple d'empilement est donné sur la figure 2C pour former cette fois une structure de mémoire non-volatile de type FTJ. La couche active située entre les électrodes a ici pour particularité d'être formée d'un empilement de couches diélectriques 65, 66 à base de matériaux diélectriques distincts. Une première couche diélectrique 65 correspond dans cet exemple particulier à un diélectrique ferroélectrique par exemple du HfO₂ dopé au Si ou du HfZrO₂, cette première couche diélectrique est revêtue ici d'une couche deuxième couche diélectrique 66 par exemple à base d'Al₂O₃.

Par souci de simplification, l'un ou l'autre des empilements des figures représentés sur la figure 2A, 2B, 2C sont disposés sous forme planaire. Toutefois, comme on peut le voir sur la figure 1B, un agencement particulier d'empilement réparti en 3D sur plusieurs plans distincts et non-parallèles est ici prévu de sorte à conférer à la structure mémoire NVM une surface développée importante tout en limitant l'encombrement dans le plan (autrement dit dans une direction parallèle au plan [O ;x ;y] sur la figure 1B.

Une amélioration de la surface développée de la structure mémoire NVM permet, notamment lorsqu'il s'agit d'une FeRAM, d'augmenter sa fenêtre mémoire et de mieux séparer ses états mémoire. Un telle amélioration permet, notamment lorsqu'il s'agit d'une FTJ d'obtenir une diminution de la résistance totale de la structure et de pouvoir, à densité de courant constante, augmenter le courant injecté. Lorsque la structure NVM est de type OxRAM une augmentation de la surface développée permet de pouvoir diminuer la tension dite « de forming » nécessaire à la modification de son état conducteur par création de filaments conducteurs et donc de limiter la consommation.

En variante des exemples décrits précédemment, on peut prévoir une structure NVM formée d'un empilement mémoire de type CBRAM, comportant entre une électrode inférieure et une électrode supérieure, au moins une couche d'électrolyte.

Une des électrodes peut être par exemple en Cu ou Ag, tandis que l'autre électrode est prévue en Pt ou TiN ou TaN ou W. Le matériau actif formant l'électrolyte peut être par exemple un chalcogénure par exemple du GeSe, ou du GeTe, ou du GeSbTe ou un oxyde métallique tel que du HfO₂, ou du Al₂O₃, ou du Ta₂O₅.

On se réfère à présent à la figure 3 qui illustre un exemple de structure S possible à partir de laquelle un dispositif tel que décrit précédemment peut être formé.

Cette structure S comprend un substrat 10 sur lequel un ou plusieurs composants électroniques, en particulier des transistors T₁₁, T₁₂ sont agencés. Les transistors T₁₁, T₁₂ ont une région de canal agencée dans une couche semi-conductrice 11 superficielle du substrat 10. Le substrat 10 peut être par exemple un substrat massif ou bien un substrat de type semiconducteur sur isolant et en particulier de type SOI (« Silicon On Insulator » ou « silicium sur isolant »).

Les transistors T₁₁, T₁₂ sont ici recouverts d'une ou plusieurs couches isolantes 12, 13 à travers lesquelles un ou plusieurs éléments conducteurs 14 traversants, connectés au(x) transistor(s) sont prévus. Des étapes de fabrication de type communément appelées de « front-end-of-line » (FEOL) où des composants (transistors, condensateurs, résistances) sont formés à partir d'une couche semi-semi-conductrice du substrat ont ainsi ici été effectuées pour réaliser un tel dispositif.

L'ensemble peut être ensuite avantageusement recouvert d'une partie, représentée de manière schématique par un bloc 20 en trait discontinu, formée d'une ou plusieurs couches isolantes et d'au moins un étage ou niveau métallique d'interconnexion formé de vias et des lignes conductrices horizontales dans cette ou ces couches isolantes.

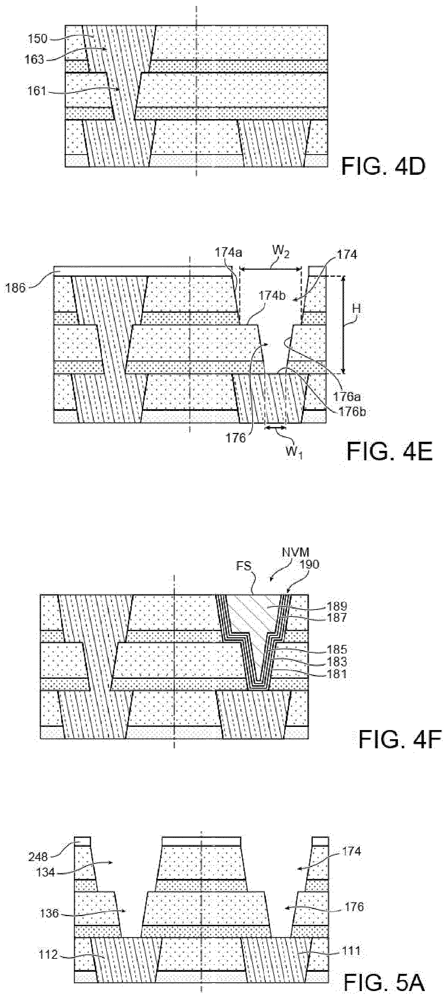

Un premier exemple de procédé de réalisation d'un dispositif microélectronique tel que décrit précédemment va à présent être donné en liaison avec les figures 4A-4F.

La structure S décrite précédemment sert ici dans cet exemple de structure de départ pour le procédé.

On revêt tout d'abord cette structure S d'une ou plusieurs couches isolantes, ici par exemple d'un empilement d'une couche isolante 103 en un premier matériau tel que par exemple du nitrure de silicium et d'une autre couche isolante 105 en un deuxième matériau tel que par exemple de l'oxyde de silicium.

Une première ligne conductrice 111 d'un x-1^{ème} (avec x supérieur ou égal à 2) niveau d'interconnexion Mx-1 et une deuxième ligne conductrice 112 du même niveau métallique d'interconnexion Mx-1 sont ensuite formées. Pour cela, on réalise typiquement, des tranchées dans les couches isolantes 103, 105 que l'on comble ensuite par au moins un matériau conducteur, par exemple du Cu.

La première ligne conductrice 111 et la deuxième ligne conductrice 112 formées (figure 4A) sont agencées dans un même premier plan parallèle ou sensiblement parallèle à un plan principal du substrat (i.e. un plan passant par le substrat 10 dans la structure S et qui est parallèle au plan [O ;x ;y] du repère [O ;x ;y ;z] donné sur la figure 4A).

On forme ensuite une ou plusieurs couches isolantes recouvrant la première ligne conductrice 111 et la deuxième ligne conductrice 112 et la couche isolante 105. Dans l'exemple de réalisation illustré sur la figure 4B, un empilement formé d'une alternance de couches 123a, 123b en un premier matériau isolant tel par exemple du nitrure de silicium et de couches 125a, 125b en un deuxième matériau isolant tel que de l'oxyde de silicium est réalisé.

On forme ensuite dans l'épaisseur isolante 123a-125b ainsi créée au moins une tranchée 134 et au moins un trou 136 situé dans le prolongement de cette tranchée 134. La tranchée 134 a ici une dimension critique (plus petite dimension mesurée parallèlement au plan principal du substrat) plus importante que celle du trou 136. Typiquement, la tranchée 134 s'étend principalement dans une direction horizontale autrement dit parallèle au plan principal du substrat, tandis que le trou 136 s'étend principalement dans une direction réalisant un angle non-nul avec celle de la tranchée 134 et de préférence verticale, autrement dit orthogonalement au plan principal du substrat.

Pour réaliser la tranchée 134 et le trou 136 dans son prolongement, on peut procéder de différentes manières.

Une manière de type communément appelée « via-first » consiste à réaliser une ouverture à travers toute l'épaisseur isolante 123a-125a pour former le trou 136 puis on forme la tranchée 134 dans les couches isolantes 123b-125b. Une autre manière de type communément appelée « Line-first » consiste à réaliser une ouverture à travers les couches isolantes 125b-123b supérieures pour former la tranchée 134 puis, graver le fond de la tranchée 134 afin de réaliser le trou 136 dans les couches isolantes 123a-125a et dans le prolongement de cette tranchée 134.

La ou les gravures de l'épaisseur isolante 123a-125a pour former le trou 136 et la tranchée 134 sont typiquement effectuées à travers au moins une ouverture d'un masquage 148 disposé en regard de la première ligne conductrice 111. Le masquage 148 peut être un masque de résine, en particulier de résine photosensible ou un masque dur, par exemple en carbone amorphe. Par exemple une gravure sèche à base de CF₄ peut être mise en œuvre.

Ensuite, on remplit la tranchée 134 et le trou 136 à l'aide d'au moins un matériau conducteur 150, qui peut être formé d'un empilement de plusieurs couches métalliques, par exemple un empilement de TaN, de Ta, et de Cu. Un tel remplissage est typiquement réalisé comme sur la figure 4D, après avoir retiré le premier masquage 148, par dépôt puis planarisation CMP (CMP pour « Chemical Mechanical Polishing », i.e. polissage mécanochimique).

La tranchée 134 remplie de matériau conducteur 150 forme une troisième ligne conductrice 163 horizontale, tandis que le trou 136 rempli de matériau conducteur 150 forme une via conducteur 161 autrement dit un élément conducteur vertical. La troisième ligne conductrice 163 réalisée appartient ainsi à un x^{ème} niveau Mx de lignes conductrices ou métalliques.

On forme ensuite dans la ou les couches isolantes 123a-125a un trou 176 ayant un fond dévoilant la première ligne conductrice 111 et une tranchée 174 dans la ou les couches isolantes 123b-125b. De même, on peut, pour cela, réaliser un enchainement d'étapes de type « line first » ou « via first ». La tranchée 174 a ici une dimension critique W2 (plus petite dimension mesurée parallèlement au plan principal du substrat) plus importante que celle W1 du trou 176 et s'étend typiquement principalement dans une direction horizontale. Le trou 176 s'étend dans une direction typiquement verticale.

On forme ensuite un empilement 190 mémoire comprenant au moins une couche d'électrode inférieure, d'au moins un couche de matériau actif et au moins une couche d'électrode supérieure, la couche de matériau actif étant agencée entre la couche d'électrode inférieure et la couche d'électrode supérieure. L'empilement est réalisé de sorte à tapisser les parois latérales 174a et le fond 174b de la tranchée 174 et à tapisser les parois latérales 176a et le fond 176b du trou 176. Dans le cas d'un empilement FeRAM, la couche d'électrode inférieure peut être par exemple à base de W, ou de TiN ou formée d'un empilement Ti/TiN. La couche d'électrode supérieure peut être par exemple à base de W, ou de TiN. La couche de matériau actif peut être une couche de diélectrique ferroélectrique tel que par exemple du HfO₂ dopé au silicium ou du HfZrO₂.

Selon un exemple de réalisation particulier illustré sur la figure 4F, pour former l'électrode inférieure on tapisse tout d'abord le trou 176 et la tranchée 174 d'un empilement de couches 181, 183 par exemple à base de Ti et de TiN et d'épaisseur comprise par exemple entre 5 nm et 20 nm. On dépose ensuite une couche 185 de diélectrique ferroélectrique par exemple à base de HfZrO₂ et d'épaisseur qui peut être comprise par exemple entre 5 nm et 15 nm. Puis, on dépose une couche 187 par exemple à base de TiN et d'épaisseur qui peut être comprise par exemple entre 5 nm et 20 nm. Les couches 181, 183, 185, 187 peuvent être formées par exemple par un procédé de dépôt de type ALD (pour « Atomic Layer Deposition ») afin d'obtenir une répartition conforme sur les parois latérales de la tranchée 174 et du trou 176 ainsi qu'au fond du trou 176. On peut ensuite achever le remplissage de la tranchée 174 et du trou 176 par dépôt d'un matériau métallique 189, par exemple tel que du W. La tranchée 174 et le trou 176 sont alors de préférence entièrement comblés. La région centrale de la structure mémoire est ainsi principalement formée de ce matériau métallique 189.

Dans l'exemple de réalisation qui vient d'être décrit, on forme le via conducteur 161 et la troisième ligne conductrice 163 avant même de réaliser le trou 176 et la tranchée 174 dans lesquels l'empilement de mémoire non-volatile NVM est prévu.

Une variante de réalisation prévoit de former concomitamment les trous 136, 176 d'accueil respectivement du via conducteur et de l'empilement mémoire. De préférence, la réalisation des tranchées 174, 184 d'accueil respectivement de la troisième ligne conductrice 163 et de l'empilement mémoire est également effectuée de manière concomitante.

Ainsi, dans l'exemple de réalisation illustré sur la figure 5A, après avoir formé les lignes conductrices 111, 112 puis recouvert ces lignes de l'épaisseur 123a-125b de couches isolantes, on forme, par un procédé de type « line first » ou bien de type « via first », les trous 176, 136 et les tranchées 174, 134 en effectuant une ou plusieurs gravures concomitantes dans l'épaisseur isolante 123a-125b. La gravure peut être mise en œuvre à travers un masquage 248.

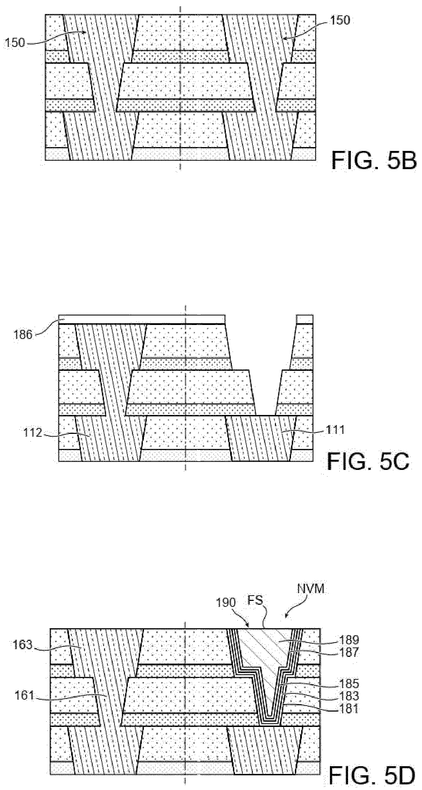

Ensuite (figure 5B), on effectue un remplissage des trous 136, 176 et tranchées 134, 174 par le biais d'au moins un matériau conducteur 150, typiquement déposé concomitamment dans les trous 176, 136 et dans les tranchées 174, 134 et par exemple formé d'un empilement de TaN, de Ta, et de cuivre.

Puis, on forme un masquage 186 en regard de la deuxième ligne conductrice 112 et de la troisième ligne conductrice 163. Ce masquage 186, typiquement sous forme de résine photosensible ou d'un masque dur ne s'étend pas en regard de la première ligne conductrice 111 et comporte ainsi une ouverture en regard de la première ligne conductrice 111.

On effectue ensuite (figure 5C) un retrait du matériau conducteur 150 du trou 176 et de la tranchée 174 non protégées par le masquage 186. Une gravure par exemple à l'aide d'une gravure humide, typiquement à l'aide de HNO₃ ou NH₄OH peut être pour cela mise en œuvre.

Puis, après avoir retiré le masquage 186 par exemple à l'aide d'un plasma, on remplit ensuite à nouveau le trou 176 et la tranchée 134 à l'aide cette fois d'un empilement mémoire. Un empilement mémoire de couches 181, 183, 185, 187, 189 tel que décrit précédemment peut être par exemple utilisé ou bien un empilement tel que décrit précédemment en lien avec l'une ou l'autre des figures 2A à 2C.

En variante de l'un ou l'autre des exemples de réalisation décrits précédemment il est possible pour former la structure NVM, de partir d'une structure différente de celle décrite sur la figure 3. Par exemple, on peut partir d'une structure telle qu'illustrée sur la figure 4A et dans laquelle les lignes conductrices 111, 112 ont déjà été réalisées ou bien d'une structure telle sur la figure 4B et dans laquelle les lignes conductrices 111, 112 ont déjà été réalisées et recouvertes d'une épaisseur isolante.

La structure mémoire NVM dont la réalisation vient d'être décrite a, de par la configuration de la tranchée et du trou dans laquelle elle est formée notamment pour particularité d'avoir au niveau de sa face supérieure FS une zone occupée par l'électrode supérieure et le ou les matériau(x) métalliques en contact avec cette électrode bien plus importante que celle de la ou les couches de matériau actif et de l'électrode inférieure. Cela permet de faciliter une prise de contact sur l'électrode supérieure et d'éviter des courts circuits.

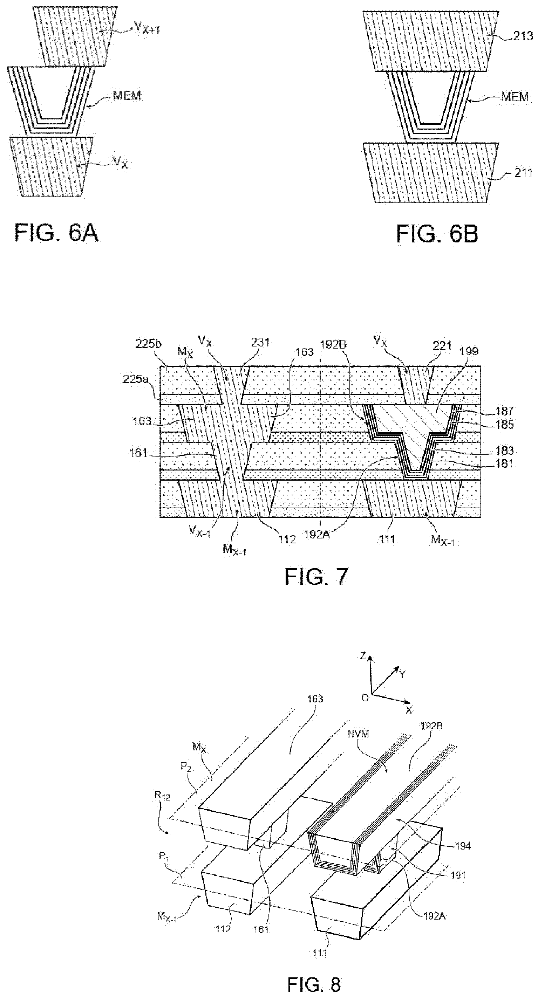

Dans une réalisation alternative illustrée sur la figure 6A, qui ne fait pas partie de la présente invention et où l'on forme un empilement mémoire MEM uniquement dans une portion de trou entre deux portions de vias conducteurs Vx+1, Vx, on risque, contrairement à l'agencement proposé pour la structure NVM, de réaliser un court-circuit en cas de désalignement.

De même dans une autre réalisation alternative illustrée sur la figure 6B (qui ne fait pas partie de la présente invention) où l'on forme un empilement mémoire MEM uniquement dans un trou de via entre deux lignes conductrices 211, 213 de niveaux distincts, on crée, contrairement à l'agencement proposé pour la structure NVM, un court-circuit.

Une fois la structure de mémoire NVM formée, d'autres niveaux métalliques d'interconnexion supplémentaires peuvent ensuite être réalisés sur le niveau Mx dans laquelle la troisième ligne conductrice 163 et la partie supérieure de la structure NVM se situent.

Ainsi, on peut prévoir de former notamment un élément conducteur ou un via conducteur 221 sur la structure NVM dont la réalisation vient d'être décrite. Dans l'exemple de réalisation particulier illustré sur la figure 7, ce via conducteur 221 prend contact sur la portion supérieure 192A élargie de la structure de mémoire empilée et en particulier sur une couche ou sur le matériau métallique 199 de remplissage formant l'électrode ou disposé sur l'électrode supérieure de la structure mémoire NVM. La forme de cette portion supérieure et la configuration de l'empilement de couches 181, 183, 185, 187, 189 formant la structure NVM permet ici d'éviter tout risque de court-circuit.

Le via conducteur 221 peut être agencé au même niveau Vx de via qu'un autre via conducteur 231 prenant lui contact sur la troisième ligne conductrice 163 de niveau Mx de lignes métalliques.

Pour former ces vias conducteurs 221, 231, on peut partir d'un dispositif tel que décrit précédemment en lien avec la figure 4F ou la figure 5D, que l'on revêt d'une ou plusieurs couches isolantes, par exemple d'une couche isolante 223a en nitrure de silicium et d'une couche isolante 223a en oxyde de silicium.

On réalise ensuite des trous dans les couches isolantes 223a, 223a que l'on comble ensuite par au moins un matériau conducteur.

D'autres niveaux métalliques et en particulier une ou plusieurs lignes conductrices supplémentaires sur et en contact des vias conducteurs 221, 231 (non représentés sur la figure 7) peuvent être ensuite éventuellement formées.

Dans un exemple de réalisation particulier illustré sur la figure 8, une portion supérieure de la structure non-volatile (NVM) forme une quatrième ligne conductrice 194 du même niveau métallique d'interconnexion Mx que la troisième ligne conductrice 163 et se prolonge en un autre via conducteur 191 pour contacter la première ligne conductrice 111.

L'ensemble formé par la quatrième ligne conductrice 194 prolongé par l'autre via conducteur 191 peut avoir, dans un plan de coupe transversal (plan parallèle au plan [O ;x ;z] sur la figure 8 et passant par le quatrième ligne conductrice 194 et l'autre via conducteur 191) un profil sensiblement identique à celui de l'ensemble formé par la troisième ligne conductrice 163 et le via conducteur 161. La structure NVM sous forme d'une quatrième ligne conductrice 194 et du via conducteur 191 peut ainsi avantageusement présenter une section transversale totale (section prise parallèlement au plan [O ;x ;z]) sensiblement identique à la section transversale de la troisième ligne conductrice 163 et du via conducteur 161. Là encore, la structure NVM peut être intégrée à un niveau Mx de métal et à une région R12 inter-niveaux, en suivant des règles de dessin semblables à celles adoptées pour former les lignes conductrices du niveau Mx et vias Vx sans que l'on ait à prévoir de dimensions spécifiques pour cette structure.

## Revendications

1. Dispositif microélectronique comprenant :
- un substrat (10) comportant une pluralité de niveaux métalliques d'interconnexions (Mx-1, Mx) superposés,
- une structure de mémoire non-volatile (NVM) agencée sur une première ligne conductrice (111) d'un premier niveau métallique d'interconnexion (Mx-1), la structure de mémoire non-volatile (NVM) comprenant un empilement (190, 60) comportant une électrode inférieure (63, 183) et une électrode supérieure (67, 67', 187) et au moins une couche de matériau actif (65, 65', 66, 185) entre l'électrode inférieure et l'électrode supérieure, le dispositif comprenant en outre:
- une deuxième ligne conductrice (112) dudit premier niveau métallique d'interconnexion (Mx-1), la deuxième ligne conductrice étant distincte de la première ligne conductrice, la première ligne conductrice et la deuxième ligne conductrice étant agencées dans un même premier plan (P1) parallèle ou sensiblement parallèle à un plan principal du substrat,
- une troisième ligne conductrice (163) appartenant à un deuxième niveau métallique d'interconnexion (Mx) supérieur par rapport audit premier niveau (Mx-1) d'interconnexions, la troisième ligne conductrice (163) étant agencée dans un deuxième plan (P2) parallèle au plan principal du substrat et au-dessus du premier plan de sorte que le premier plan est agencé entre le deuxième plan et le plan principal du substrat, la troisième ligne conductrice (163) étant connectée à la deuxième ligne conductrice (112) par l'intermédiaire d'un via conducteur (161), le via conducteur (161) s'étendant dans une région intermédiaire (R12) située entre ledit premier plan (P1) et ledit deuxième plan (P2), l'électrode inférieure (63, 183), l'électrode supérieure (67, 67', 187) et ladite au moins une couche de matériau actif (65, 65', 66, 185) dudit empilement (190, 60) de la structure non-volatile (NVM) s'étendant dans le niveau métallique d'interconnexion (Mx) supérieur et dans ladite région intermédiaire (R12), la troisième ligne conductrice (163) et le via conducteur (161) traversant une épaisseur isolante (123a-125b), l'épaisseur isolante s'étendant sur la première ligne conductrice (111) et la deuxième ligne conductrice (112),
ledit empilement (190, 60) de la structure non-volatile (NVM) étant disposé au fond d'un trou (176) sur la première ligne conductrice (111),
**caractérisé en ce que** ledit empilement tapisse des parois latérales ainsi qu'un fond d'une tranchée (174) et du trou (176) situé dans le prolongement de cette tranchée, le trou et la tranchée étant agencés dans ladite épaisseur isolante (123a-125b).

2. Dispositif microélectronique selon la revendication 1, comprenant en outre :
- un premier via conducteur supérieur (221) ayant une extrémité inférieure disposée sur et en contact de la structure de mémoire non-volatile (NVM) et s'étendant, dans une épaisseur isolante (225a-225b), entre cette extrémité inférieure et une extrémité supérieure,
- un deuxième via conducteur supérieur (231) ayant une extrémité inférieure disposée sur et en contact avec la troisième ligne conductrice (163), et s'étendant dans ladite épaisseur isolante (225a-225b) entre son extrémité inférieure et une extrémité supérieure,
le premier via conducteur supérieur (221) et le deuxième via conducteur supérieur (231) ayant des hauteurs respectives égales mesurées entre d'une part leurs extrémité inférieure et d'autre part leur extrémité supérieure.

3. Dispositif microélectronique selon la revendication 2, dans lequel ledit via conducteur (161) a une extrémité inférieure en contact avec la deuxième ligne conductrice (112) et une extrémité supérieure en contact avec la troisième ligne conductrice (163), ledit via conducteur (161) et la troisième ligne conductrice (163) étant agencées dans au moins une couche isolante (123a-125b), une face inférieure de la couche isolante (123a-125b) étant disposée sur et en contact de la première ligne conductrice (111) et de la deuxième ligne conductrice (112),
la structure non-volatile (NVM) s'étendant entièrement dans ladite couche isolante, entre la face inférieure de la couche isolante et un plan passant à la fois par une face supérieure de la couche isolante opposée à la face inférieure, l'extrémité inférieure du premier via conducteur supérieur (221) et par l'extrémité inférieure du deuxième via conducteur supérieur (231).

4. Dispositif microélectronique selon l'une des revendications 1 à 3, dans lequel la structure de mémoire non-volatile (NVM) comprend une portion supérieure (192B) et une portion inférieure (192A), la portion inférieure (192A) s'étendant dans ladite région intermédiaire (R12) et ayant une hauteur égale ou sensiblement égale à la hauteur dudit via conducteur (161), la portion supérieure (192B) étant agencée dans le deuxième plan et ayant une section transversale donnée, la portion inférieure (192A) ayant une section transversale différente de la section transversale donnée.

5. Dispositif microélectronique selon l'une des revendications 1 à 4, dans lequel la hauteur H cumulée du trou (176) et de la tranchée (174) est sensiblement égale à la hauteur hc cumulée du via conducteur (161) et de la troisième ligne conductrice (163).

6. Dispositif microélectronique selon l'une des revendications 4 ou 5, dans lequel ledit trou (176) est prévu avec une largeur W1 et dans lequel la tranchée (174) est prévue avec une largeur W2 telle que W2 > W1, de sorte que la structure non-volatile (NVM) comporte une portion inférieure (192A) et une portion supérieure (192B) élargie par rapport à la portion inférieure.

7. Dispositif microélectronique selon l'une des revendications précédentes, l'électrode inférieure (63, 183), l'électrode supérieure (67, 67',187) et l'au moins une couche de matériau actif (65, 65', 66, 185) dudit empilement (190, 60) de la structure non-volatile (NVM) s'étendent sous forme d'une quatrième ligne conductrice (194) distincte de la troisième ligne conductrice (163) et appartenant au deuxième niveau métallique d'interconnexion (Mx) et sous la forme d'au moins un autre via conducteur (191) dans le prolongement de la quatrième ligne conductrice (194), ledit autre via conducteur (191) étant prévu pour prendre contact sur la première ligne conductrice (111).

8. Dispositif microélectronique selon la revendication 7, dans lequel la quatrième ligne conductrice (194) et ledit autre via (191), ont une section transversale sensiblement identique à la section transversale de la troisième ligne conductrice (163) et dudit via conducteur (161).

9. Dispositif microélectronique selon l'une des revendications 1 à 8, comprenant en outre un via conducteur (221) supplémentaire agencé sur et en contact d'une portion supérieure (192B) de la structure mémoire.

10. Dispositif microélectronique selon la revendication 9, dans lequel la couche d'électrode supérieure est dotée ou revêtue d'une zone de matériau conducteur (189) de remplissage du trou (176) et de la tranchée (174), ledit via conducteur (221) supplémentaire étant disposé sur et en contact de ladite portion supérieure (192B) de la structure mémoire sans être disposé en contact avec le matériau actif ou l'électrode inférieure.

11. Dispositif microélectronique selon l'une des revendications précédentes, dans lequel la structure de mémoire non-volatile (NVM) est :
- de type FeRAM, le matériau actif étant formé d'au moins une couche de diélectrique ferroélectrique, ou
- de type OXRAM, le matériau actif étant formé d'au moins une couche de diélectrique, ou
- de type CBRAM, le matériau actif étant formé d'au moins une couche formant un électrolyte, ou
- de type FTJ, le matériau actif étant formé d'au moins une couche de diélectrique ferroélectrique en contact avec une couche d'un autre matériau diélectrique.

12. Procédé de fabrication d'un dispositif microélectronique selon l'une des revendications 1 à 11, muni d'une structure de mémoire non-volatile (NVM) formée d'un empilement comportant au moins une électrode inférieure et au moins une électrode supérieure et au moins un matériau actif entre l'électrode inférieure et l'électrode supérieure, le procédé comprenant les étapes suivantes :
- prévoir un substrat (10) revêtu d'au moins un couche isolante (103, 105), une première ligne conductrice (111) et une deuxième ligne conductrice (112) d'un niveau d'interconnexion donné (Mx-1) s'étendant dans la couche isolante et dans un même premier plan (P1) parallèle à un plan principal du substrat (10),
- former une épaisseur isolante (123a-125b) sur la première ligne conductrice (111), la deuxième ligne conductrice (112) et ladite couche isolante (103, 105),
- former dans ladite épaisseur isolante (123a-125b) un trou (176) dévoilant la première ligne conductrice (111) et une tranchée (174) dans le prolongement de ce trou (176),
- déposer dans la tranchée (174) et dans le trou (176) un empilement comprenant au moins une couche d'électrode inférieure (181, 183, 61, 63), au moins une couche de matériau actif (185, 65, 65', 66) et au moins une couche d'électrode supérieure (187, 199, 67, 69), ledit empilement tapissant des parois latérales (174a, 176a) et un fond (176b, 174b) du trou (176) et de la tranchée (174).

13. Procédé selon la revendication 12, comprenant en outre, la formation dans ladite épaisseur isolante (123a-125b) d'un via conducteur (161) en contact avec la deuxième ligne conductrice (112) et d'une troisième ligne conductrice (163) sur ledit via conducteur (161).

14. Procédé selon la revendication 13, dans lequel la réalisation du via conducteur (161) et de la troisième ligne conductrice (163) comprend des étapes de :
- réalisation d'un premier masquage (148) en regard de la première ligne conductrice (111) et comportant au moins une ouverture en regard de la deuxième ligne conductrice (112),
- gravure à travers ladite ouverture du premier masquage (148) d'une autre tranchée (134) et d'un autre trou (136) dans le prolongement de ladite autre tranchée (134) et ayant un fond dévoilant la deuxième ligne conductrice (112),
- remplissage de l'autre tranchée (134) et de l'autre trou (136) à l'aide d'au moins un matériau conducteur (150),
- retrait dudit premier masquage (148) et formation d'un deuxième masquage (186) comportant au moins une ouverture en regard de la première ligne conductrice (111), - gravure de l'épaisseur isolante (123a-125b) à travers ladite ouverture dudit deuxième masquage (186) pour former ladite tranchée (174) et ledit trou (176).

15. Procédé selon la revendication 13, dans lequel la réalisation du via conducteur (161) et de la troisième ligne conductrice (163) comprend la formation d'une autre tranchée (134) et d'un autre trou (136) dans le prolongement de ladite autre tranchée (134), ledit autre trou (136) ayant un fond dévoilant la deuxième ligne conductrice (112),
ledit trou (176) dévoilant la première ligne conductrice (111) et ledit autre trou (136) dévoilant la deuxième ligne conductrice (112) étant formés concomitamment.

16. Procédé selon la revendication 15, dans lequel ladite tranchée (174),
ladite autre tranchée (134), ledit trou (176) et ledit autre trou (136) sont formés par gravure de l'épaisseur isolante (123a-125b) à travers plusieurs ouvertures d'un premier masquage (248), le procédé comprenant des étapes de :
- remplissage de ladite tranchée (174), de ladite autre tranchée (134), dudit trou (176) et dudit autre trou (136) à l'aide d'au moins un matériau conducteur (150),
- retrait dudit premier masquage (248) et formation d'un deuxième masquage (186) en regard de la deuxième ligne conductrice (112) et de la troisième ligne conductrice (163), le deuxième masquage (186) comportant au moins une ouverture en regard de la première ligne conductrice (111),
- retrait dudit matériau conducteur (150) de ladite tranchée (174) et dudit trou (176) par gravure à travers l'ouverture dudit deuxième masquage (186), de sorte à libérer à nouveau ladite tranchée (174) et ledit trou (176),
- formation dudit empilement dans ladite tranchée (176) et ledit trou (174).

17. Procédé selon l'une des revendications 12 à 16, le dépôt de l'empilement (190) étant un dépôt conforme réalisé en particulier par ALD.

18. Procédé selon l'une des revendications 12 à 17, dans lequel ladite au moins une couche de matériau actif (185, 65, 65', 66) est formée :
- d'un diélectrique ferroélectrique, en particulier un oxyde tel que du HfO₂ dopé au Si ou du HfZrO₂, ou
- d'un oxyde diélectrique tel que du HfO₂, ou
- d'un oxyde métallique tel que du HfO₂ ou du Al₂O₃ ou du Ta₂O₅ ou un chalcogénure tel que du GeSe ou du GeTe ou du GeSbTe, ou
- d'un empilement d'un diélectrique ferroélectrique et d'un autre diélectrique.

19. Procédé selon la revendication 18, dans lequel l'électrode inférieure et l'électrode supérieure sont formées :
- d'une couche en un premier matériau choisi parmi un ou plusieurs des matériaux suivants : Ti, TiN, W, et/ou
- d'une couche en un matériau métallique choisi parmi un ou plusieurs des matériaux suivants : W, Cu, Al, AlCu, AlSi.

20. Procédé de fabrication selon l'une des revendications 12 à 19, dans lequel le dépôt dans la tranchée (174) et dans le trou (176) dudit empilement est suivi du remplissage de la tranchée (174) et du trou (176) par dépôt d'un matériau métallique (189), de sorte à combler le trou (176) et la tranchée (174).

## Patentansprüche

1. Mikroelektronische Vorrichtung, umfassend:
- ein Substrat (10), das eine Vielzahl von übereinanderliegenden metallischen Verbindungsebenen (Mx-1, Mx) aufweist,
- eine nichtflüchtige Speicherstruktur (NVM), die auf einer ersten Leiterbahn (111) einer ersten metallischen Verbindungsebene (Mx-1) angeordnet ist, wobei die nichtflüchtige Speicherstruktur (NVM) einen Stapel (190, 60) umfasst, der eine untere Elektrode (63, 183) und eine obere Elektrode (67, 67', 187) und wenigstens eine Schicht aus aktivem Material (65, 65', 66, 185) zwischen der unteren Elektrode und der oberen Elektrode aufweist, wobei die Vorrichtung ferner umfasst:
- eine zweite Leiterbahn (112) der ersten metallischen Verbindungsebene (Mx-1), wobei die zweite Leiterbahn von der ersten Leiterbahn verschieden ist, wobei die erste Leiterbahn und die zweite Leiterbahn in derselben ersten Ebene (P1) parallel oder im Wesentlichen parallel zu einer Hauptebene des Substrats angeordnet sind,
- eine dritte Leiterbahn (163), die zu einer im Verhältnis zu der ersten Verbindungsebene (Mx-1) höheren zweiten metallischen Verbindungsebene (Mx) gehört, wobei die dritte Leiterbahn (163) in einer zweiten Ebene (P2) parallel zu der Hauptebene des Substrats und oberhalb der ersten Ebene angeordnet ist, so dass die erste Ebene zwischen der zweiten Ebene und der Hauptebene des Substrats angeordnet ist, wobei die dritte Leiterbahn (163) mit der zweiten Leiterbahn (112) über einen Via-Leiter (161) verbunden ist, wobei sich der Via-Leiter (161) in einem Zwischenbereich (R12) erstreckt, der sich zwischen der ersten Ebene (P1) und der zweiten Ebene (P2) befindet, wobei die untere Elektrode (63, 183), die obere Elektrode (67, 67', 187) und die wenigstens eine Schicht aus aktivem Material (65, 65', 66, 185) des Stapels (190, 60) der nichtflüchtigen Struktur (NVM) in der oberen metallischen Verbindungsebene (Mx) und in dem Zwischenbereich (R12) erstrecken, wobei die dritte Leiterbahn (163) und der Via-Leiter (161) eine Isolierdicke (123a-125b) durchqueren, wobei sich die Isolierdicke auf der ersten Leiterbahn (111) und der zweiten Leiterbahn (112) erstreckt, wobei der Stapel (190, 60) der nichtflüchtigen Struktur (NVM) am Boden eines Lochs (176) auf der ersten Leiterbahn (111) angeordnet ist, **dadurch gekennzeichnet, dass** der Stapel die Seitenwände sowie einen Boden eines Grabens (174) und des Lochs (176) bedeckt, das sich in Verlängerung dieses Grabens befindet, wobei das Loch und der Graben in der Isolierdicke (123a-125b) angeordnet sind.

2. Mikroelektronische Vorrichtung nach Anspruch 1, ferner umfassend:
- einen ersten oberen Via-Leiter (221), der ein unteres Ende aufweist, das auf und in Kontakt mit der nichtflüchtigen Speicherstruktur (NVM) angeordnet ist und sich in einer Isolierdicke (225a-225b) zwischen diesem unteren Ende und einem oberen Ende erstreckt,
- einen zweiten oberen Via-Leiter (231), der ein unteres Ende aufweist, das auf und in Kontakt mit der dritten Leiterbahn (163) angeordnet ist und sich in der Isolierdicke (225a-225b) zwischen seinem unteren Ende und einem oberen Ende erstreckt,
wobei der erste obere Via-Leiter (221) und der zweite obere Via-Leiter (231) jeweils gleiche Höhen aufweisen, gemessen zwischen einerseits ihrem unteren Ende und andererseits ihrem oberen Ende.

3. Mikroelektronische Vorrichtung nach Anspruch 2, wobei der Via-Leiter (161) ein unteres Ende in Kontakt mit der zweiten Leiterbahn (112) und ein oberes Ende in Kontakt mit der dritten Leiterbahn (163) aufweist, wobei der Via-Leiter (161) und die dritte Leiterbahn (163) in wenigstens einer Isolierschicht (123a-125b) eingerichtet sind, wobei eine Unterseite der Isolierschicht (123a-125b) auf und in Kontakt mit der ersten Leiterbahn (111) und mit der zweiten Leiterbahn (112) angeordnet ist,
wobei sich die nichtflüchtige Struktur (NVM) vollständig in der Isolierschicht zwischen der Unterseite der Isolierschicht und einer Ebene erstreckt, die sowohl durch eine Oberseite der Isolierschicht, die der Unterseite gegenüberliegt, das untere Ende des ersten oberen Via-Leiters (221) und durch das untere Ende des zweiten oberen Via-Leiters (231) verläuft.

4. Mikroelektronische Vorrichtung nach einem der Ansprüche 1 bis 3, wobei die nichtflüchtige Speicherstruktur (NVM) einen oberen Abschnitt (192B) und einen unteren Abschnitt (192A) umfasst, wobei sich der untere Abschnitt (192A) in dem Zwischenbereich (R12) erstreckt und eine Höhe aufweist, die gleich oder im Wesentlichen gleich der Höhe des Via-Leiters (161) ist, wobei der obere Abschnitt (192B) in der zweiten Ebene eingerichtet ist und einen gegebenen Querschnitt aufweist, wobei der untere Abschnitt (192A) einen Querschnitt aufweist, der sich von dem gegebenen Querschnitt unterscheidet.

5. Mikroelektronische Vorrichtung nach einem der Ansprüche 1 bis 4, wobei die kumulative Höhe H des Lochs (176) und des Grabens (174) im Wesentlichen gleich der kumulativen Höhe hc des Via-Leiters (161) und der dritten Leiterbahn (163) ist.

6. Mikroelektronische Vorrichtung nach einem der Ansprüche 4 oder 5, wobei das Loch (176) mit einer Breite W1 vorgesehen ist und wobei der Graben (174) mit einer Breite W2, W2 > W1, vorgesehen ist, so dass die nichtflüchtige Struktur (NVM) einen unteren Abschnitt (192A) und einen oberen Abschnitt (192B) aufweist, der im Verhältnis zu dem unteren Abschnitt verbreitert ist.

7. Mikroelektronische Vorrichtung nach einem der vorhergehenden Ansprüche, wobei sich die untere Elektrode (63, 183), die obere Elektrode (67, 67', 187) und die wenigstens eine Schicht aus aktivem Material (65, 65', 66, 185) des Stapels (190, 60) der nichtflüchtigen Struktur (NVM) in Form einer vierten Leiterbahn (194), die von der dritten Leiterbahn (163) verschieden ist und zu der zweiten metallischen Verbindungsebene (Mx) gehört, und in Form wenigstens eines weiteren Via-Leiters (191) in Verlängerung der vierten Leiterbahn (194) erstrecken, wobei der weitere Via-Leiter (191) vorgesehen ist, Kontakt mit der ersten Leiterbahn (111) herzustellen.

8. Mikroelektronische Vorrichtung nach Anspruch 7, wobei die vierte Leiterbahn (194) und der weitere Via-Leiter (191) einen Querschnitt aufweisen, der im Wesentlichen mit dem Querschnitt der dritten Leiterbahn (163) und des Via-Leiters (161) identisch ist.

9. Mikroelektronische Vorrichtung nach einem der Ansprüche 1 bis 8, die ferner einen zusätzlichen Via-Leiter (221) umfasst, der auf und in Kontakt mit einem oberen Abschnitt (192B) der Speicherstruktur eingerichtet ist.

10. Mikroelektronische Vorrichtung nach Anspruch 9, wobei die obere Elektrodenschicht mit einem Bereich aus leitfähigem Material (189) zum Füllen des Lochs (176) und des Grabens (174) versehen oder beschichtet ist, wobei der zusätzliche Via-Leiter (221) auf und in Kontakt mit dem oberen Abschnitt (192B) der Speicherstruktur angeordnet ist, ohne in Kontakt mit dem aktiven Material oder der unteren Elektrode angeordnet zu sein.

11. Mikroelektronische Vorrichtung nach einem der vorhergehenden Ansprüche, wobei die nichtflüchtige Speicherstruktur (NVM) ist:
- vom Typ FeRAM, wobei das aktive Material aus wenigstens einer ferroelektrischen Dielektrikumschicht gebildet ist, oder
- vom Typ OXRAM, wobei das aktive Material aus wenigstens einer Dielektrikumschicht gebildet ist, oder
- vom Typ CBRAM, wobei das aktive Material aus wenigstens einer elektrolytbildenden Schicht gebildet ist, oder
- vom Typ FTJ, wobei das aktive Material aus wenigstens einer ferroelektrischen Dielektrikumschicht in Kontakt mit einer Schicht aus einem weiteren dielektrischen Material gebildet ist.

12. Verfahren zur Herstellung einer mikroelektronischen Vorrichtung nach einem der Ansprüche 1 bis 11, die mit einer nichtflüchtigen Speicherstruktur (NVM) versehen ist, die aus einem Stapel gebildet ist, der wenigstens eine untere Elektrode und wenigstens eine obere Elektrode und wenigstens ein aktives Material zwischen der unteren Elektrode und oberen Elektrode aufweist, wobei das Verfahren die folgenden Schritte umfasst:
- Bereitstellen eines Substrats (10), das mit wenigstens einer Isolierschicht (103, 105), einer ersten Leiterbahn (111) und einer zweiten Leiterbahn (112) einer gegebenen Verbindungsebene (Mx-1) beschichtet ist, die sich in der Isolierschicht und in derselben ersten gegebenen Ebene (P1) parallel zu einer Hauptebene des Substrats (10) erstreckt,
- Bilden einer Isolierdicke (123a-125b) auf der ersten Leiterbahn (111), der zweiten Leiterbahn (112) und der Isolierschicht (103, 105),
- Bilden, in der Isolierdicke (123a-125b), eines Lochs (176), das die erste Leiterbahn (111) und einen Graben (174) in Verlängerung dieses Lochs (176) offenlegt,
- Ablegen, in dem Graben (174) und in dem Loch (176), eines Stapels, der wenigstens eine untere Elektrodenschicht (181, 183, 61, 63), wenigstens eine Schicht aus aktivem Material (185, 65, 65', 66) und wenigstens eine obere Elektrodenschicht (187, 199, 67, 69) umfasst, wobei der Stapel die Seitenwände (174a, 176a) und einen Boden (176b, 174b) des Lochs (176) und des Grabens (174) bedeckt.

13. Verfahren nach Anspruch 12, das ferner das Formen eines Via-Leiters (161) in Kontakt mit der zweiten Leiterbahn (112) und einer dritten Leiterbahn (163) auf dem Via-Leiter (161) in der Isolierdicke (123a-125b) umfasst.

14. Verfahren nach Anspruch 13, wobei die Herstellung des Via-Leiters (161) und der dritten Leiterbahn (163) Schritte umfasst:
- Herstellen einer ersten Maskierung (148), die der ersten Leiterbahn (111) zugewandt ist und wenigstens eine Öffnung umfasst, die der zweiten Leiterbahn (112) zugewandt ist,
- Ätzen, durch die Öffnung der ersten Maskierung (148), eines weiteren Grabens (134) und eines weiteren Lochs (136) in Verlängerung des weiteren Grabens (134) und mit einem Boden, der die zweite Leiterbahn (112) offenlegt,
- Füllen des weiteren Grabens (134) und des weiteren Lochs (136) mit wenigstens einem leitenden Material (150),
- Entfernen der ersten Maskierung (148) und Bilden einer zweiten Maskierung (186), die wenigstens eine Öffnung aufweist, die der ersten Leiterbahn (111) zugewandt ist,
- Ätzen der Isolierdicke (123a-125b) durch die Öffnung der zweiten Maskierung (186), um den Graben (174) und das Loch (176) zu bilden.

15. Verfahren nach Anspruch 13, wobei die Herstellung des Via-Leiters (161) und der dritten Leiterbahn (163) die Bildung eines weiteren Grabens (134) und eines weiteren Lochs (136) in Verlängerung des weiteren Grabens (134) umfasst, wobei das weitere Loch (136) einen Boden aufweist, der die zweite Leiterbahn (112) offenlegt,
wobei das Loch (176), das die erste Leiterbahn (111) offenlegt, und das weitere Loch (136), das die zweite Leiterbahn (112) offenlegt, gleichzeitig gebildet werden.

16. Verfahren nach Anspruch 15, wobei der Graben (174), der weitere Graben (134), das Loch (176) und das weitere Loch (136) durch Ätzen der Isolierdicke (123a-125b) durch mehrere Öffnungen einer ersten Maskierung (248) gebildet werden, wobei das Verfahren Schritte umfasst:
- Füllen des Grabens (174), des weiteren Grabens (134), des Lochs (176) und des weiteren Lochs (136) mit wenigstens einem leitenden Material (150),
- Entfernen der ersten Maskierung (248) und Bilden einer zweiten Maskierung (186), die der zweiten Leiterbahn (112) und der dritten Leiterbahn (163) zugewandt ist, wobei die zweite Maskierung (186) wenigstens eine Öffnung aufweist, die der ersten Leiterbahn (111) zugewandt ist,
- Entfernen des leitenden Materials (150) aus dem Graben (174) und dem Loch (176) durch Ätzen durch die Öffnung der zweiten Maskierung (186), so dass der Graben (174) und das Loch (176) wieder frei werden,
- Bilden des Stapels in dem Graben (176) und dem Loch (174).

17. Verfahren nach einem der Ansprüche 12 bis 16, wobei die Ablage des Stapels (190) eine ordnungsgemäße Ablage ist, die insbesondere durch ALD durchgeführt wird.

18. Verfahren nach einem der Ansprüche 12 bis 17, wobei die wenigstens eine Schicht aus aktivem Material (185, 65, 65', 66) gebildet ist:
- aus einem ferroelektrischen Dielektrikum, insbesondere einem Oxid wie Sidotiertes HfO₂ oder HfZrO₂, oder
- aus einem Dielektrizitätsoxid wie HfO₂, oder
- aus einem Metalloxid wie HfO₂ oder Al₂O₃ oder Ta₂O₅ oder einem Chalkogenid wie GeSe oder GeTe oder GeSbTe, oder
- aus einem Stapel aus einem ferroelektrischen Dielektrikum und einem weiteren Dielektrikum.

19. Verfahren nach Anspruch 18, wobei die untere Elektrode und die obere Elektrode gebildet sind:
- aus einer Schicht aus einem ersten Material, das aus einem oder mehreren der folgenden Materialien ausgewählt ist: Ti, TiN, W und/oder
- aus einer Schicht aus einem metallischen Material, das aus einem oder mehreren der folgenden Materialien ausgewählt ist: W, Cu, Al, AlCu, AlSi.

20. Herstellungsverfahren nach einem der Ansprüche 12 bis 19, wobei dem Ablegen in dem Graben (174) und in dem Loch (176) des Stapels das Füllen des Grabens (174) und des Lochs (176) durch Ablegen eines metallischen Materials (189) folgt, so dass das Loch (176) und der Graben (174) aufgefüllt werden.

## Claims

1. Microelectronic device comprising:
- a substrate (10) comprising a plurality of superimposed metal interconnection levels (Mx-1, Mx),
- a non-volatile memory (NVM) structure arranged on a first conductive line (111) of a first metal interconnection level (Mx-1), the non-volatile memory (NVM) structure comprising a stack (190, 60) comprising a lower electrode (63, 183) and an upper electrode (67, 67', 187) and at least one active material layer (65, 65', 66, 185) between the lower electrode and the upper electrode, the device further comprising:
- a second conductive line (112) of said first metal interconnection level (Mx-1), the second conductive line being distinct from the first conductive line, the first conductive line and the second conductive line being arranged in the same first plane (P1) parallel or substantially parallel to a main plane of the substrate,
- a third conductive line (163) belonging to a second upper metal interconnection level (Mx) in relation to said first interconnection level (Mx-1), the third conductive line (163) being arranged in a second plane (P2) parallel to the main plane of the substrate and above the first plane such that the first plane is arranged between the second plane and the main plane of the substrate, the third conductive line (163) being connected to the second conductive line (112) by means of a conductive via (161), the conductive via (161) extending into an intermediate region (R12) located between said first plane (P1) and said second plane (P2), the lower electrode (63, 183), the upper electrode (67, 67', 187) and said at least one active material layer (65, 65', 66, 185) of said stack (190, 60) of the non-volatile memory (NVM) structure extending into the upper metal interconnection level (Mx) and into said intermediate region (R12), the third conductive line (163) and the conductive via (161) passing through an insulating thickness (123a-125b), the insulating thickness extending over the first conductive line (111) and the second conductive line (112), said stack (190, 60) of the non-volatile memory (NVM) being disposed at the bottom of hole (176) on the first conductive line (111),
**characterized in that**
said stack lines the side walls as well as a bottom of a trench (174) and of the hole (176) located in the extension of this trench, the hole and the trench being arranged in said insulating thickness (123a-125b).

2. Microelectronic device according to claim 1, further comprising:
- a first upper conductive via (221) having a lower end disposed on and in contact with the non-volatile memory (NVM) structure and extending, in an insulating thickness (225a-225b), between this lower end and an upper end,
- a second upper conductive via (231) having a lower end disposed on and in contact with the third conductive line (163), and extending in said insulating thickness (225a-225b) between the lower end thereof and an upper end,
the first upper conductive via (221) and the second upper conductive via (231) having equal respective heights measured between the lower end thereof on the one hand and the upper end thereof on the other hand.

3. Microelectronic device according to claim 2, wherein said conductive via (161) has a lower end in contact with the second conductive line (112) and an upper end in contact with the third conductive line (163), said conductive via (161) and the third conductive line (163) being arranged in at least one insulating layer (123a-125b), a lower face of the insulating layer (123a-125b) being disposed on and in contact with the first conductive line (111) and with the second conductive line (112),
the non-volatile memory (NVM) structure extending entirely in said insulating layer, between the lower face of the insulating layer and a plane passing through both an upper face of the insulating layer opposite the lower face, the lower end of the first upper conductive via (221) and through the lower end of the second upper conductive via (231).

4. Microelectronic device according to one of claims 1 to 3, wherein the non-volatile memory (NVM) structure comprises an upper portion (192B) and a lower portion (192A), the lower portion (192A) extending into said intermediate region (R12) and having a height equal to or substantially equal to the height of said conductive via (161), the upper portion (192B) being arranged in the second plane and having a given cross section, the lower portion (192A) having a cross section different from the given cross section.

5. Microelectronic device according to one of claims 1 to 4, wherein the cumulative height H of the hole (176) and of the trench (174) is substantially equal to the cumulative height hc of the conductive via (161) and of the third conductive line (163).

6. Microelectronic device according to one of claims 4 or 5, wherein said hole (176) is provided with a width W1 and wherein the trench (174) is provided with a width W2 such as W2 > W1, such that the non-volatile memory (NVM) structure comprises a lower portion (192A) and an upper portion (192B) enlarged in relation to the lower portion.

7. Microelectronic device according to one of the preceding claims, the lower electrode (63, 183), the upper electrode (67, 67', 187) and the at least one active material layer (65, 65', 66, 185) of said stack (190, 60) of the non-volatile memory (NVM) structure extend in the form of a fourth conductive line (194) distinct from the third conductive line (163) and belonging to the second metal interconnection level (Mx) and in the form of at least one other conductive via (191) in the extension of the fourth conductive line (194), said other conductive via (191) being provided to make contact on the first conductive line (111).

8. Microelectronic device according to claim 7, wherein the fourth conductive line (194) and said other via (191), have a cross section substantially identical to the cross section of the third conductive line (163) and of said conductive via (161).

9. Microelectronic device according to one of claims 1 to 8, further comprising an additional conductive via (221) arranged on and in contact with an upper portion (192B) of the memory structure.

10. Microelectronic device according to claim 9, wherein the upper electrode layer is provided or coated with an area of conductive material (189) for filling the hole (176) and the trench (174), said additional conductive via (221) being disposed on and in contact with said upper portion (192B) of the memory structure without being disposed in contact with the active material or the lower electrode.

11. Microelectronic device according to one of the preceding claims, wherein the non-volatile memory (NVM) structure is:
- of the FeRAM type, the active material being formed of at least one layer of ferroelectric dielectric, or
- of the OXRAM type, the active material being formed of at least one dielectric layer, or
- of the CBRAM type, the active material being formed of at least one layer forming an electrolyte, or
- of the FTJ type, the active material being formed of at least one layer of ferroelectric dielectric in contact with a layer of another dielectric material.

12. Method for manufacturing a microelectronic device according to one of claims 1 to 11, provided with a non-volatile memory (NVM) structure formed of a stack comprising at least one lower electrode and at least one upper electrode and at least one active material between the lower electrode and the upper electrode, the method comprising the following steps of:
- providing a substrate (10) coated with at least one insulating layer (103, 105), a first conductive line (111) and a second conductive line (112) of a given interconnection level (Mx-1) extending in the insulating layer and in the same first plane (P1) parallel to a main plane of the substrate (10),
- forming an insulating thickness (123a-125b) on the first conductive line (111), the second conductive line (112) and said insulating layer (103, 105),
- forming in said insulating thickness (123a-125b), a hole (176) revealing the first conductive line (111) and a trench (174) in the extension of this hole (176),
- depositing in the trench (174) and in the hole (176) a stack comprising at least one lower electrode layer (181, 183, 61, 63), at least one active material layer (185, 65, 65', 66) and at least one upper electrode layer (187, 199, 67, 69), said stack lining the side walls (174a, 176a) and a bottom (176b, 174b) of the hole (176) and of the trench (174).

13. Method according to claim 12, further comprising forming in said insulating thickness (123a-125b) a conductive via (161) in contact with the second conductive line (112) and a third conductive line (163) on said conductive via (161).

14. Method according to claim 13, wherein producing the conductive via (161) and the third conductive line (163) comprises steps of:
- producing a first masking (148) facing the first conductive line (111) and comprising at least one opening facing the second conductive line (112),
- etching through said opening of the first masking (148) another trench (134) and another hole (136) in the extension of said other trench (134) and having a bottom revealing the second conductive line (112),
- filling the other trench (134) and the other hole (136) using at least one conductive material (150),
- removing said first masking (148) and forming a second masking (186) comprising at least one opening facing the first conductive line (111), etching the insulating thickness (123a-125b) through said opening of said second masking (186) to form said trench (174) and said hole (176).

15. Method according to claim 13, wherein producing the conductive via (161) and the third conductive line (163) comprises forming another trench (134) and another hole (136) in the extension of said other trench (134), said other hole (136) having a bottom revealing the second conductive line (112),
said hole (176) revealing the first conductive line (111) and said other hole (136) revealing the second conductive line (112) being formed concomitantly.

16. Method according to claim 15, wherein said trench (174), said other trench (134), said hole (176) and said other hole (136) are formed by etching the insulating thickness (123a-125b) through several openings of a first masking (248), the method comprising steps of:
- filling said trench (174), said other trench (134), said hole (176) and said other hole (136) using at least one conductive material (150),
- removing said first masking (248) and forming a second masking (186) facing the second conductive line (112) and the third conductive line (163), the second masking (186) comprising at least one opening facing the first conductive line (111),
- removing said conductive material (150) from said trench (174) and from said hole (176) by etching through the opening of said second masking (186), so as to again release said trench (174) and said hole (176),
- forming said stack in said trench (176) and said hole (174).

17. Method according to one of claims 12 to 16, the deposition of the stack (190) being a compliant deposition performed in particular by ALD.

18. Method according to one of claims 12 to 17, wherein said at least one active material layer (185, 65, 65', 66) is formed:
- of a ferroelectric dielectric, in particular an oxide such as Si-doped HfO₂ or HfZrO₂, or
- of a dielectric oxide such as HfO₂, or
- of a metal oxide such as HfO₂ or Al₂O₃ or Ta₂O₅ or of a chalcogenide such as GeSe or GeTe or GeSbTe, or
- of a stack of a ferroelectric dielectric and of another dielectric.

19. Method according to claim 18, wherein the lower electrode and the upper electrode are formed:
- of a layer made of a first material selected from one or more of the following materials: Ti, TiN, W, and/or
- of a layer made of a metal material selected from one or more of the following materials: W, Cu, Al, AlCu, AlSi.

20. Manufacturing method according to one of claims 12 to 19, wherein the deposition in the trench (174) and in the hole (176) of said stack is followed by filling the trench (174) and the hole (176) by depositing a metal material (189), so as to fill the hole (176) and the trench (174).
